(19) Europäisches Patentamt
European Patent Office
Office européen des brevets

(11) EP 0 394 741 B1

(12) EUROPÄISCHE PATENTSCHRIFT

(45) Veröffentlichungstag und Bekanntmachung des Hinweises auf die Patenterteilung:
**25.06.1997 Patentblatt 1997/26**

(51) Int Cl.[6]: **G03F 7/40**

(21) Anmeldenummer: **90106832.0**

(22) Anmeldetag: **10.04.1990**

(54) **Verfahren zur Erzeugung ätzresistenter Strukturen**

Process for producing etch resistant structures

Procédé pour la formation des structures resistantes à la morsure

(84) Benannte Vertragsstaaten:
**BE CH DE ES FR GB IT LI NL SE**

(30) Priorität: **24.04.1989 DE 3913431**

(43) Veröffentlichungstag der Anmeldung:
**31.10.1990 Patentblatt 1990/44**

(73) Patentinhaber: **SIEMENS AKTIENGESELLSCHAFT**
**80333 München (DE)**

(72) Erfinder:
- **Sezi, Recai, Dr.**
  **D-8551 Röttenbach (DE)**
- **Sebald, Michael, Dr. rer. nat.**
  **D-8521 Hessdorf (DE)**
- **Leuschner, Rainer, Dr. rer. nat.**
  **D-8521 Grossenseebach (DE)**
- **Birkle, Siegfried, Dr. rer. nat.**
  **D-8552 Höchstadt (DE)**
- **Ahne, Hellmut, Dr.**
  **D-8551 Röttenbach (DE)**

(56) Entgegenhaltungen:
**EP-A- 0 187 421**

- **PATENT ABSTRACTS OF JAPAN vol. 5, no. 74 (E-57)(746) 16 Mai 1981, & JP-A-56 23744 (OKI DENKI KOGYO) 06 März 1981,**
- **Patent Abstracts of Japan, vol.7, no.18(P-170)[1163], 25-JAN-1982; & JP-A-57 173831 (OKI DENKI KOGYO KK)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 394 741 B1

## Beschreibung

Die Erfindung betrifft ein ätzresistentes Photoresistsystem, insbesondere für den tiefen UV-Bereich, sowie ein Verfahren zum maßgenauen Erzeugen von Strukturen, insbesondere im Sub-µm-Bereich auf Halbleitersubstraten unter Verwendung dieses Photoresistsystems.

Einer der wichtigsten Prozeßschritte in der Mikroelektronik ist das Plasmaätzen. Damit lassen sich Substrate, die eine aus Halbleitern, Isolationsmaterial oder auch Metallen bestehende Oberfläche aufweisen, strukturieren. Für viele Prozesse wird dazu ein halogenhaltiges Plasma verwendet, welches zum Beispiel aus den Ätzgasen $CF_4$, $SF_6$, $BCl_3$, $Cl_2$, $CHCl_3$, $CHF_3$, Perfluorpropan oder Hexafluorethan besteht. So kann zum Beispiel ein Siliziumsubstrat mit den Gasen $CHF_3$ oder $CF_4$ geätzt werden. Um dabei eine Struktur im Siliziumsubstrat zu erzeugen, müssen die nicht zu ätzenden Bereiche der Oberfläche mit einem ätzresistenten Material abgedeckt werden. Dieses wiederum wird auf lithographischem Wege mittels einer Strahlung strukturiert. Durch Einwirkung von sichtbarem oder UV-Licht, Gamma- oder Elektronenstrahlen wird die chemische Struktur des Ätzresists derart verändert, daß zum Beispiel in dessen von der Strahlung erfaßten Bereichen eine im Vergleich zu den nicht bestrahlten Bereichen veränderte Löslichkeit gegenüber einem Entwickler erzeugt wird. Dadurch lassen sich die leichter löslichen Bereiche der Ätzresistschicht herauslösen, wobei eine räumliche Struktur der schwerer löslichen Bereiche verbleibt. Diese müssen in dem zur Ätzung des Substrats verwendeten Ätzplasma eine ausreichende Stabilität aufweisen. Als Resist werden überwiegend organische Polymere eingesetzt. Dabei ist bekannt, daß Resists, die vorwiegend aromatische Kohlenwasserstoffe enthalten, gegenüber einem halogenhaltigen Plasma eine wesentlich höhere Stabilität aufweisen als solche Resists mit rein aliphatischer Struktur.

Neben den resistspezifischen Parametern wie Strukturierbarkeit oder Ätzresistenz sind zum Erzeugen einer hoch aufgelösten Struktur noch weitere technologische und physikalische Parameter zu beachten. So fließen zum Beispiel bei einem photolithographischen Verfahren in die Gleichung

$$CD = f \frac{\lambda}{NA}$$

neben der Wellenlänge λ über die numerischer Apertur NA auch Eigenschaften der zur Belichtung verwendeten Stepper bzw. der Stepperlinse mit ein, die die erreichbare minimale Strukturgröße (Critical Dimension = CD) beeinflussen. Da übliche Photoresists mit Belichtungswellenlängen von 365 nm oder 436 nm strukturiert werden, läßt sich nach der oben genannten Gleichung die Auflösung des Photoresists durch Verwendung einer kürzeren Belichtungswellenlänge, zum Beispiel 248 nm, weiter verbessern. Für diese im DUV-Bereich liegende Wellenlänge sind jedoch keine ausreichend ätzresistenten alkalisch entwickelbaren Resists bekannt, die in ausreichend starker Schichtdicke (≥ 900 nm) Halb-µm-Strukturen erzeugen. So besitzen die meisten kommerziell erhältlichen Resists (zum Beispiel auf Novolakbasis) aufgrund ihrer aromatischen Struktur vor allem im tiefen UV-Bereich, wie zum Beispiel bei 248 nm, eine starke unbleichbare Absorption und sind daher zur Erzeugung feiner Strukturen mit DUV ungeeignet. Eine gute Ausbleichbarkeit ist eine weitere Anforderung, die an einen hochauflösenden Resist gestellt wird. Ein Resist soll bei der Belichtung anfänglich eine hohe Absorption aufweisen, um eine entsprechend hohe Empfindlichkeit des Resists zu gewährleisten, im Verlaufe der Belichtung aber für die verwendete Strahlung transparent werden, damit auch tiefer liegende Schichtbereiche des Photoresists von einer ausreichend hohen Lichtintensität erreicht werden können.

Dieses Problem wird bisher so gelöst, daß ein DUV-transparentes Material photostrukturiert wird und erst danach durch eine geeignete Behandlung eine Ätzresistenz in diesen Photolackstrukturen erzeugt wird.

So wird zum Beispiel in deer veröffentlichten Patentanmeldung GB-A 2 121 197 der positive Elektronenresist Polymethacryloylchlorid nach der lithographischen Strukturierung mit aromatischen Aminen und Silizium- oder Aluminiumverbindungen in organischer Lösung nachbehandelt, um die Ätzresistenz zu erhöhen.

Die Nachteile dieses Verfahrens bestehen jedoch insbesondere darin, daß das Resistmaterial hydrolyseempfindlich ist und mit niemals zu vermeidender Feuchtigkeit korrosive Salzsäure bildet. Auch sind diese Reaktionen sehr schwer zu steuern.

In der Patentanmeldung EP-A 00 98 922 wird ein Zweilagensystem beschrieben, bei dem die UV-Absorption der oberen Resistschicht durch Behandlung mit Dämpfen von Naphthalin, Antracen etc. erhöht wird. Dadurch wird die Ätzresistenz dieser Schicht erhöht, gleichzeitig damit aber auch die Absorption für Wellenlängen unter 300 nm, für die die Resistschicht dann kaum noch empfindlich ist. Dabei der Prozeß so komplex, daß er für den Fertigungseinsatz ungeeignet ist.

Auch das in der US-PS 4 289 573 beschriebene Verfahren zur Erhöhung der Ätzresistenz von Resists durch Behandlung mit Natriumhydroxid oder Kaliumhydroxid ist für Fertigungszwecke ungeeignet, da Alkaliionen in der Siliziumtechnologie vollkommen unerwünscht sind. Außerdem ist auch die Durchführung dieses Prozesses äußerst komplex.

Aufgabe der vorliegenden Erfindung ist es daher, ein einfach durchzuführendes Photostrukturierungsverfahren für

den DUV-Bereich anzugeben, mit dem bei guter Ätzresistenz des Resists eine maßgenaue Strukturerzeugung möglich ist.

Diese Aufgabe wird erfindungsgemäß durch ein Verfahren nach Anspruch 1 gelost.

Weitere Ausgestaltungen der Erfindung sind den Unteransprüchen zu entnehmen.

Das erfindungsgemäß verwendete Photoresistsystem zeichnet sich dadurch aus, daß die beiden Komponenten relativ unabhängig voneinander wählbar sind. So kann der Photoresist unabhängig von der gewünschten Ätzresistenz derart ausgewählt werden, daß eine hohe Auflösung, verbunden mit einer hohen Transparenz des Basispolymeren für eine Strahlung von gegebener Wellenlänge erzielt wird.

Das zur Erhöhung der Ätzresistenz verwendete Reagenz dagegen kann unabhängig von seinem Verhalten gegenüber der Beleichtungsstrahlung gewählt werden, da seine Absorption für diese Strahlung die Strukturierung des Photoresists nicht beeinflußt. Lediglich die reaktiven Gruppen sind auf die reaktionsfähigen Gruppen des Photoresists (Komponente a)) abgestimmt, so daß eine chemische Anbindung unter einfachen Bedingungen, zum Beispiel bei Raumtemperatur und im offenen System durchführbar ist. Zur einfachen Handhabung trägt unter anderem das wäßrige System bei, in welchem das Reagenz als Lösung oder Emulsion vorliegt. Zum Umgang mit dem Reagenz bzw. mit dem gesamten Photoresistsystem sind daher lediglich einfache bekannte Vorrichtungen erforderlich. Diese müssen weder für Vakuum- noch für Temperaturschritte geeignet sein. Insgesamt garantiert das erfindungsgemäße Photoresistsystem also eine gute Strukturierbarkeit und eine hohe Ätzresistenz, insbesondere gegen halogenhaltiges Plasma.

Keine erhöhte Absorption gegenüber tiefem UV-Licht (z. B. 240 bis 280 nm) weisen zum Beispiel Polymere auf, die als reaktionsfähige Gruppen Anhydrid- oder Epoxidgruppen besitzen. Vorteilhafterweise wird daher ein Photoresist gewählt, der aus einem Basispolymeren und einer photoaktiven Komponente besteht, wobei die photoaktive Komponente auf die Bestrahlungswellenlänge abgestimmt ist und das Basispolymer die erwähnten Anhydridgruppen enthält. Die Anhydridfunktionen können dabei cyclisch oder linear sein und sowohl in der Haupt- als auch in einer Seitenkette des Basispolymeren enthalten sein.

Gut zugänglich sind Basispolymere, die durch Polymerisation oder Copolymerisation von olefinisch ungesättigten Carbonsäureanhydriden erhalten werden. Beispiel für solche Monomere stellen die im folgenden angegebenen Strukturen A, B, C oder D dar,

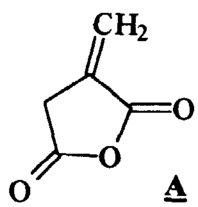

A

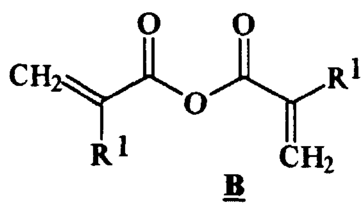

B

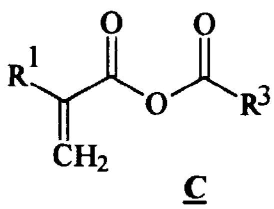

C

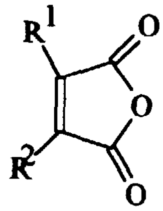

D

wobei die Reste $R^1$ und $R^2$ für H oder Alkyl stehen und $R^3$ einen Alkyl- oder Arylrest darstellt. Auch Copolymere mit anderen Monomeren sind möglich, wobei der Anteil des Anhydridfunktionen tragenden Monomers zwischen 1 und 100 Prozent eingestellt wird.

Vorteilhaft und gut zugänglich ist z.B. auch ein Basispolymer, das zu 10 bis 55 Mol-Prozent aus Maleinsäureanhydridmonomeren abgeleitet ist und beispielsweise als alternierendes Copolymer mit Styrol als Comonomer eingesetzt wird.

Geeignete photoaktive Komponenten für insbesondere tiefes UV-Licht sind in ausreichender Anzahl bekannt. Gut geeignet sind Chinondiazide, die zum Beispiel einer der angegebenen Strukturformeln E, F oder G gehorchen oder von einer dieser Strukturen abgeleitet sind,

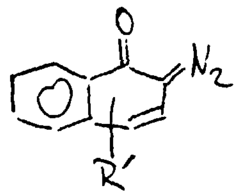 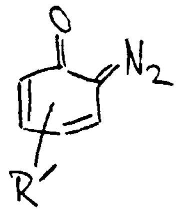 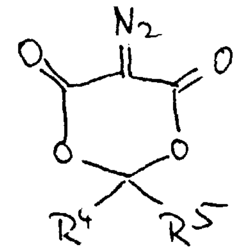

E F G

wobei $R^4$ und $R^5$ unabhängig voneinander für einen beliebigen organischen Rest stehen, R' $-SO_3R$ oder $-CO_2R$ bedeutet und R für Alkyl, Aryl, Halogenalkyl, Halogenaryl oder Halogen steht.

Die vollständige chemische Struktur einer photoaktiven Komponente ist auf das verwendete Basispolymer abgestimmt. Geht man zum Beispiel von den reaktiven Carbonsäure- bzw. Sulfonsäurederivaten aus, die von den Verbindungen E bis G abgeleitet sind, so sind deren Umsetzungsprodukte mit aromatischen oder aliphatischen H-aciden Verbindungen wie Alkoholen, Phenolen und Aminen bevorzugt. Gut geeignet in Verbindung mit maleinsäurehaltigen Basispolymeren ist der 4-Sulfonsäureester von Naphthochinondiazid mit mehrwertigen Phenolen, beispielsweise mit Bisphenol A.

Ein auf die obengenannten Beispiele für den Photoresist abgestimmtes Reagenz weist als reaktive Gruppen bevorzugt primäre oder sekundäre Aminofunktionen auf. Die zumindest eine reaktive Gruppe tragenden Verbindungen können voll aromatische oder nur teilweise aromatische Struktur besitzen und zum Beispiel ein arylsubstituiertes aliphatisches Amin, vorzugsweise ein Diamin, darstellen. Ist das Agens eine mehrfunktionelle Verbindung, so sind neben der Aminogruppe auch OH-Gruppen möglich. Die Aminogruppe ist zur Reaktion mit einer Anhydridgruppe besonders geeignet, wobei gemäß der Reaktion

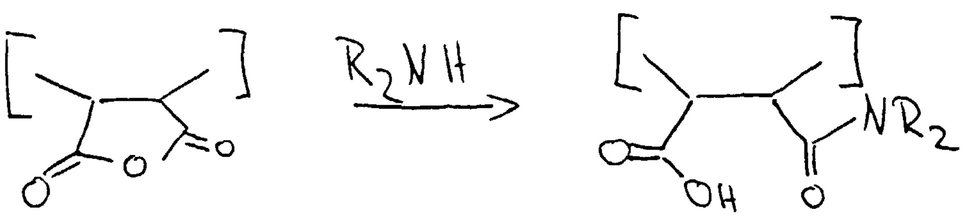


im ersten Schritt eine Amidocarbonsäure gebildet wird, die ihrerseits nun mit weiteren reaktiven Gruppen zu reagieren vermag, zum Beispiel mit weiteren Amino- oder Alkoholgruppen. Ähnlich reagieren epoxidhaltige Photoresists bzw. Basispolymere mit Aminogruppen, wobei im ersten Reaktionsschritt α-, β-Aminoalkohole gebildet werden, die weitere Reaktionen mit zum Beispiel Epoxidgruppen eingehen können.

Wird für das Reagenz eine mehrfunktionelle Verbindung gewählt, so tritt als weitere positive Wirkung eine Vernetzung des Photoresists ein, wodurch die Ätzresistenz weiter erhöht wird.

Als weitere positive Nebenwirkung ist ein Aufquellen der Resiststrukturen durch die Behandlung mit dem Reagenz zu beobachten. Der steuerbare Schichtzuwachs schafft eine Ätzreserve durch größere Schichtdicke. So kann der Resist in dünner Schicht mit guter Auflösung strukturiert und mit dem Reagenz schließlich bis zur ausreichenden Schichtdicke bzw. bis zur ausreichenden Ätzresistenz aufgedickt werden.

Vorteilhafte Verwendung findet das erfindungsgemäße Photoresistsystem in einem Verfahren zur maßgenauen photolithographischen Strukturerzeugung bei mikroelektronischen Bauelementen, insbesondere mit Strukturbreiten im Sub-µm-Bereich. Dabei kann eine, auf einem Substrat aufgebrachte, strukturierend belichtete, entwickelte und mit einem Reagenz behandelte Photoresiststruktur als Ätzmaske in einem halogenhaltige Ätzgase enthaltenden Plasmaätzverfahren dienen. Dazu wird das zu ätzende Substrat, welches zum Beispiel eine aus Halbleitermaterial, Oxid oder Metall bestehende Oberfläche aufweist, mit einem ausgewählten Photoresist beschichtet, bei einer gegebenen Wellenlänge zur Erzeugung eines latenten Bildes mit einer Strahlung belichtet und entwickelt.

Die nun räumliche Photoresiststruktur wird anschließend mit dem z.B. im wäßrigen System vorliegenden Reagenz behandelt. Da dazu keine besonderen weiteren Maßnahmen erforderlich sind, kann diese Behandlung in einfachen Apparaturen, wie zum Beispiel in einem Sprüh-, Puddle- oder Tauchentwickler, bei Raumtemperatur vorgenommen

werden. Die reaktiven Gruppen des Reagenz gehen dabei mit den in der Photoresiststruktur vorhandenen reaktionsfähigen Gruppen des Photoresists eine chemische Reaktion ein und binden das Reagenz an den Photoresist an. Aufgrund der zumindest teilweise aromatischen Struktur des Reagenz wird dadurch eine verstärkte Ätzresistenz des Photoresists gegenüber einem zum Beispiel halogenhaltigen Plasma erzeugt. Bei Verwendung von mehrfunktionellen Verbindungen als Reagenz kann die Ätzresistenz weiter gesteigert werden. Die Behandlung kann bis zur vollständigen Reaktion sämtlicher reaktionsfähiger Gruppen in der Photoresiststruktur durchgeführt werden oder in einem gewünschten Ausmaß durch die Dauer der Behandlung, durch die Konzentration des Reagenz in der Lösung oder Emulsion oder durch die Temperatur geregelt werden. Nach der Behandlung wird die Photoresiststruktur mit Alkohol, Wasser oder ähnlichem gespült und gegebenenfalls getrocknet. Neben der vorteilhaften weil einfachen Behandlung mit einem Reagenz in flüssiger Phase kann die Photoresiststruktur auch in der Gasphase behandelt werden.

Im direkten Anschluß daran können nun in einem zum Beispiel halogenhaltigen Plasma das Substrat, bzw. dessen von der Photoresiststruktur nicht bedeckte Teile geätzt werden, wobei die Photoresiststruktur aufgrund ihrer hohen Ätzresistenz gegenüber dem Plasma als Ätzmaske für das Substrat dient. Dadurch wird weiterhin garantiert, daß die Photoresiststrukturen im Verlauf des Ätzvorganges vom Plasma nicht oder nicht merklich abgetragen werden und der Ätzschritt deshalb mit hoher Maßgenauigkeit erfolgt. Das heißt, auf der Maske vorgegebene Strukturen werden ohne eine Verbreiterung, den sogenannten Maßverlust, auf das Substrat übertragen. Nur so können die Ätzprcfile steile Flanken erhalten. Im Anschluß an den Ätzschritt können weitere Maßnahmen zur Behandlung des Substrats durchgeführt wercen. Abschließend wird die Photoresiststruktur entfernt.

Im folgenden werden beispielhaft die Zusammensetzungen zweier Photoresistsysteme angegeben und ihre Verwendung im erfindungsgemäßen Verfahren anhand von zwei Ausführungsbeispielen und der dazugehörigen vier Figuren näher erläutert. Die Figuren zeigen verschiedene Verfahrensschritte bei der Erzeugung von Strukturen in bzw. auf einem Substrat im schematischen Querschnitt.

Erstes Photoresistsystem:

a1) Ein Copolymer aus Styrol und Maleinsäureanhydrid mit dem Molekulargewicht $M_n$ = 2400 (gewonnen durch radikalische Polymerisation der beiden Monomeren) stellt das Basispolymer dar. 16 Gewichtsteile davon werden mit 4 Gewichtsteilen eines Diesters von Bisphenol A mit Naphthochinondiazid-4-sulfonsäure in 80 Gewichtsteilen 2-Methoxy-l-prcpylacetat gelöst.

b1) Eine Emulsion zur Behandlung einer Photoresiststruktur besteht aus 0,5 Gewichtsteilen 3-(Aminomethyl)-benzylamin, 0,5 Gewichtsteilen Aminomethylnaphthalin, 0,5 Gewichtsteilen Emulgator (zum Beispiel Pril) und 98,5 Gewichtsteilen Wasser.

Zweites Photoresistsystem:

a2) Das Basispolymer, das wieder ein Copolymer aus Styrol und Maleinsäureanhydrid ist, jedoch mit dem Molekulargewicht $M_n$ = 6700, wird zu 13,6 Gewichtsteilen zusammen mit 3,4 Gewichtsteilen der bereits unter al verwendeten photoaktiven Komponente in 80 Gewichtsteilen 2-Methoxy-1-propylacetat gelöst.

b2) Eine Lösung zur Behandlung dieser Photoresiststruktur besteht aus einem Gewichtsteil 3-(Aminomethyl)-benzylamin, einem Gewichtsteil Aminomethylnaphthalin, 49 Gewichtsteilen Isopropylalkohol und 49 Gewichtsteilen Wasser.

Erstes Ausführungsbeispiel:

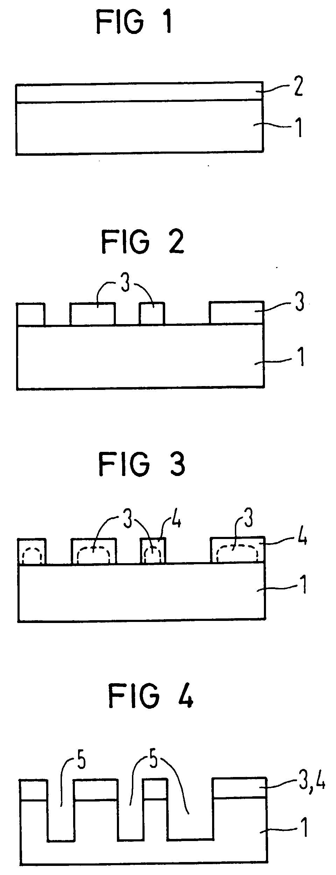

Figur 1: Auf einen Siliziumwafer als Substrat 1 wird die Resistlösung al aufgeschleudert und bei 110°C auf der Hotplate getrocknet. Die Dicke der Photoresistschicht 2 beträgt 900 nm. Durch eine Maske wird nun mit einer Dosis von 140 mJ/cm$^2$ bei einer Wellenlänge von 246 bis 268 nm kontaktbelichtet. Zur Entwicklung wird eine Mischung aus 5 Gewichtsteilen Wasser, einem Gewichtsteil des Entwicklers AZ 400 K (Hoechst AG) und 0,5 Gewichtsteilen Ammoniak verwendet.

Figur 2 zeigt die Anordnung nach ca. 45 bis 60 Sekunden Entwicklung. Die entstandenen Photoresiststrukturen 3 zeigen eine Auflösung bis zur Strukturbreite von ca. 0,5 µm. Nach erneuter Trocknung auf der Hotplate wird die Anordnung mit der Photoresiststruktur 3 für 120 Sekunden in die Emulsion b1 getaucht, herausgenommen, mit Isopropylalkohol gespült und erneut bei 110°C getrocknet.

Figur 3 zeigt die Anordnung, bei der in den oberflächennahen Bereichen 4 der Photoresiststruktur 3 durch chemische Reaktion mit der Behandlungslösung bzw. -Emulsion eine chemische Veränderung eingetreten ist. In einem Plasmareaktor wird die Anordnung nun mit einer Gasmischung, bestehend aus Tetrafluormethan plus 10 Prozent (Volumen) Sauerstoff bei 450V bias-Spannung und 30 mTorr Gasdruck geätzt.

Figur 4 zeigt die Anordnung nach dem Ätzschritt. In den von der Photoresiststruktur (3, 4) nicht bedeckten Bereichen des Substrats 1 sind Gräben 5 im Substrat entstanden, die senkrechte Flanken aufweisen.

Zweites Ausführungsbeispiel (es gelten die gleichen Figuren 1 bis 4 wie beim ersten Ausführungsbeispiel):

Ebenfalls auf einem Siliziumwafer als Substrat 1 wird die Photoresistlösung a2 aufgeschleudert und bei 110°C auf der Hotplate getrocknet. Die Schichtdicke der Photoresistschicht 2 beträgt 900 nm. Durch eine Maske wird mit 180 mJ/cm$^2$ bei einer Wellenlänge von 240 bis 260 nm kontaktbelichtet. Zur Entwicklung werden 5 Gewichtsteile Wasser mit einem Teil des käuflichen Entwicklers AZ 400 K (Firma Hoechst AG) verdünnt, mit 0,5 Gewichtsteilen Ammoniak versetzt und die Anordnung damit für 45 bis 60 Sekunden entwickelt. Die entstandenen Photoresiststrukturen 3 (Figur 2) zeigen eine Auflösung bis 0,5 µm Strukturbreite. Nach einer Trocknung bei 110°C wird die Anordnung mit den Photoresiststrukturen 3 auf dem Substrat 1 für 120 Sekunden in die Lösung b2 getaucht, anschließend mit Isopropylalkohol gespült und erneut bei 110°C getrocknet. Die Photoresiststruktur 3 weist nun chemisch veränderte oberflächennahe Bereiche 4 auf, die eine erhöhte Ätzresistenz zeigen (siehe Figur 3). Eine weitere Steigerung der Ätzresistenz kann durch eine Flutbelichtung der Resiststrukturen mit einer Dosis von ca. 50 mJ/cm$^2$ bewirkt werden. Dabei wird die chemische Reaktion des Resists mit der Behandlungslösung beschleunigt. Unter gleichen Ätzbedingungen wie im ersten Ausführungsbeispiel wird nun die von Figur 3 dargestellte Anordnung im Plasmareaktor geätzt.

Die in den Ausführungsbeispielen bestimmten Ätzraten (im halogenhaltigen Plasma) der erfindungsgemäß behandelten Photoresiststrukturen werden in einem Vergleich den Ätzraten von unbehandelten Photoresiststrukturen aus Maleinsäureanhydrid/Styrolcopolymer und einem käuflichen Entwickler gegenübergestellt.

| Zu ätzendes Material | Ätzrate |
|---|---|
| Styrol/Maleinsäureanhydrid, unbehandelt | 53 nm/min |
| Photoresist AZ 1450 J | 41 nm/min |
| Styrol/Maleinsäureanhydrid, erstes Aus führungsbeispiel, behandelt | 35 nm/min |
| Styrol/MSA, zweites Ausführungsbeispiel, behandelt | 35 nm/min |

Aus den hier dargestellten Ätzraten geht eindeutig die durch die erfindungsgemäße Behandlung bewirkte Erhöhung der Ätzresistenz gegenüber eine halogenhaltigen Ätzplasma hervor. Eine erfindungsgemäß behandelte Photoresiststruktur bzw. das erfindungsgemäße Photoresistsystem ist daher bestens zur Verwendung als Ätzmaske für halogenhaltiges Plasma geeignet.

**Patentansprüche**

**1.** Verfahren zur maßgenauen photolithographischen Strukturerzeugung, insbesondere im Sub-µm-Bereich, mit folgenden hinreichenden Schritten:

- Aufbringen einer Schicht eines gut strukturierbaren Photoresist mit einer photoaktiven Komponente und einem für die Belichtungsstrahlung hinreichend transparenten Basispolymeren, welches Anhydridgruppen als reaktive Gruppen aufweist, welcher unter Normalbedingungen beständige, aber nach der Entwicklung noch reaktionsfähige Gruppen aufweist auf ein Substrat,

- Belichten im DUV-Bereich und Entwickeln der Resistschicht zur Erzeugung einer Resiststruktur,

- Behandeln der Resiststruktur mit einem in wäßriger oder zumindest Wasser enthaltender Lösung oder Emulsion vorliegenden Reagenz, welches aormatische Strukturen besitzt und reaktive Gruppen aufweist, um eine chemische Verbindungsbildung mit den reaktionsfähigen Gruppen der erzeugten Resiststruktur zu erzielen,

- gegebenenfalls Spülen der so behandelten Resiststruktur mit Wasser, Trocknen und

- Ätzen des Substrats in einem halogenhaltigen Plasma unter Verwendung der behandelten Resiststruktur als

Ätzmaske.

2. Verfahren nach Anspruch 1,
bei dem die Behandlung der Resiststruktur mit dem Reagenz in einem Sprüh-, Puddle- oder Tauchentwickler durchgeführt wird.

3. Verfahren nach einem der Ansprüche 1 oder 2,
bei dem die Behandlung bei Raumtemperatur durchgeführt wird.

4. Verfahren nach mindestens einem der Ansprüche 1 bis 3,
bei dem die Behandlung bei Normaldruck durchgeführt wird.

5. Verfahren nach einem der Ansprüche 1 bis 4,
bei dem ein Reagenz eingesetzt wird, das als reaktive Gruppe zumindest eine primäre oder sekundäre Aminogruppe aufweist.

6. Verfahren nach Anspruch 5,
bei dem im Reagenz ein Diamin enthalten ist, welches zumindest teilweise aromatische Struktur aufweist.

7. Verfahren nach einem der Ansprüche 1 bis 6,
bei dem ein Photoresist verwendet wird, der ein zumindest von Maleinsäureanhydrid-Monomeren abgeleitetes Polymer enthält.

8. Verfahren nach Anspruch 7,
bei dem ein Resist verwendet wird, der ein alternierendes Copolymer von Maleinsäureanhydrid und Styrol enthält.

## Claims

1. Method for dimensionally accurate photolithographic structure production, in particular in the sub-µm region, having the following adequate steps:

   - deposition on a substrate of a layer of a well-structurable photoresist containing a photoactive component and a base polymer which is adequately transparent to the exposure radiation and which contains anhydride groups as reactive groups, which photoresist contains groups which are stable under normal conditions but are still reactive after development,
   - exposure in the DUV range and development of the resist layer to produce a resist structure,
   - treatment of the resist structure with a reagent present in an aqueous or at least water-containing solution or emulsion, which reagent has aromatic structures and contains reactive groups in order to achieve a chemical compound formation with the reactive groups of the resist structure produced,
   - optionally rinsing the resist structure treated in this way with water, drying and
   - etching the substrate in a halogen-containing plasma using the treated resist structure as etching mask.

2. Method according to Claim 1, wherein the treatment of the resist structure is carried out with the reagent in a spray developer, puddle developer or immersion developer. ,

3. Method according to one of Claims 1 or 2, wherein the treatment is carried out at room temperature.

4. Method according to at least one of Claims 1 to 3, wherein the treatment is carried out at normal pressure.

5. Method according to one of Claims 1 to 4, wherein a reagent is used which contains at least one primary or secondary amino group as reactive group.

6. Method according to Claim 5, wherein the reagent contains a diamine which has at least partially an aromatic structure.

7. Method according to one of Claims 1 to 6, wherein a photoresist is used which contains a polymer derived at least from maleic anhydride monomers.

8. Method according to Claim 7, wherein a resist is used which contains an alternating copolymer of maleic anhydride and styrene.

## Revendications

1. Procédé pour la formation de structures photolithographiques exactes, en particulier dans la région inférieure au µm, avec les étapes suffisantes suivantes :

   - l'application d'une couche d'une photoréserve bien structurable avec une composante photoactive et un polymère de base suffisamment transparent pour le rayonnement d'exposition, polymère de base qui présente à titre de groupes réactionnels des groupes anhydrides, photoréserve qui présente des groupes stables dans des conditions normales mais encore suffisamment réactionnels après le développement, sur un substrat,
   - l'exposition dans la gamme du DUV et le développement de la couche de réserve pour la formation d'une structure de réserve,
   - le traitement de la structure de réserve avec un réactif se trouvant en solution ou en émulsion aqueuse ou contenant du moins de l'eau, réactif qui possède des structures aromatiques et qui présente des groupes réactionnels pour réaliser la formation d'une liaison chimique avec les groupes réactionnels de la structure de réserve formée,
   - le rinçage éventuel des structures de réserve ainsi traitées, avec de l'eau, le séchage et
   - la gravure du substrat dans un plasma halogéné en utilisant la structure de réserve traitée, comme masque de gravure.

2. Procédé selon la revendication 1, dans lequel le traitement de la structure de réserve avec le réactif est effectué dans un appareil de développement par aspersion, de type Puddle ou par immersion.

3. Procédé selon l'une des revendications 1 ou 2, dans lequel le traitement est effectué à température ambiante.

4. Procédé selon au moins une des revendications 1 à 3, dans lequel le traitement est effectué à pression normale.

5. Procédé selon l'une des revendications 1 à 4, dans lequel on utilise un réactif qui présente à titre de groupe réactionnel au moins un groupe aminé primaire ou secondaire.

6. Procédé selon la revendication 5, dans lequel est contenu dans le réactif une diamine, qui présente une structure du moins partiellement aromatique.

7. Procédé selon l'une des revendications 1 à 6, dans lequel on utilise une photoréserve qui contient un polymère du moins dérivé de monomères d'anhydride maléique.

8. Procédé selon la revendication 7, dans lequel on utilise une réserve qui contient un copolymère alternant d'anhydride maléique et de styrène.

FIG 1

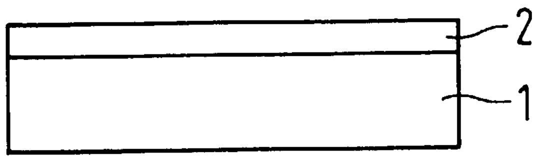


FIG 2

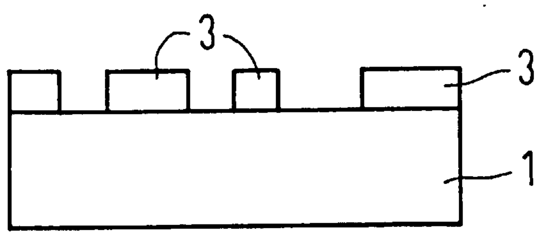


FIG 3

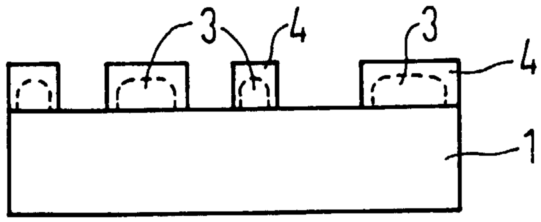


FIG 4